Europäisches Patentamt

European Patent Office

Office européen des brevets

(11) Numéro de publication : **0 506 535 B1**

# (12) FASCICULE DE BREVET EUROPEEN

(45) Date de publication du fascicule du brevet :
**29.11.95 Bulletin 95/48**

(51) Int. Cl.$^6$ : **H04B 1/66, H03H 17/02**

(21) Numéro de dépôt : **92400775.0**

(22) Date de dépôt : **23.03.92**

(54) **Procédé et système de traitement des prééchos d'un signal audio-numérique codé par transformée fréquentielle.**

(30) Priorité : **27.03.91 FR 9103715**

(43) Date de publication de la demande :
**30.09.92 Bulletin 92/40**

(45) Mention de la délivrance du brevet :
**29.11.95 Bulletin 95/48**

(84) Etats contractants désignés :
**DE ES FR GB IT NL**

(56) Documents cités :
**DE-A- 3 806 416**
**PROCEEDINGS OF THE 25TH IEEE CONFE-RENCE ON DECISION & CONTROL Décembre 1986, NEW YORK (US) pages 116 - 1121; LIND-QUIST: "USE OF SIGNAL PROCESSING ALGORITHMS IN MICROPROCESSOR-BASED CONTROL"**

(56) Documents cités :
**JAYANT & NOLL 'DIGITAL CODING OF WAVE-FORMS' 1984 , PRENTICE HALL , ENGLE-WOOD CLIFFS (US)**
**1990 INTERNATIONAL CONFERENCE ON ACOUSTICS, SPEECH, AND SIGNAL PROCES-SING vol. 2, Avril 1990, NEW YORK (US) pages 1105 - 1108; EBERLEIN ET AL.: 'AUDIO CODEC FOR 64KBIT/SEC (ISDN CHANNEL)-REQUIRE-MENTS AND RESULTS'**

(73) Titulaire : **FRANCE TELECOM**
**6, Place d'Alleray**
**F-75015 Paris (FR)**

(72) Inventeur : **Mahieux, Yannick**
**Bourg de Tonquédec**
**F-22140 Begard (FR)**

(74) Mandataire : **Fréchède, Michel et al**
**Cabinet Plasseraud**
**84, rue d'Amsterdam**
**F-75009 Paris (FR)**

EP 0 506 535 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention est relative à un procédé et à un système de traitement des prééchos d'un signal audio-numérique codé par transformée fréquentielle.

Les processus de stockage, de transmission ou de traitement des signaux sonores numérisés, de plus en plus utilisés de nos jours, se heurtent au problème du débit numérique nécessaire toujours plus important selon les applications envisagées.

Des techniques très élaborées, telles que le codage de ces signaux par transformée fréquentielle, telle'que transformée en cosinus discrète modifiée, TCDM, sont utilisées afin de diminuer le débit d'information résultant, tout en conservant sensiblement la qualité du signal d'origine. Ainsi qu'on l'a représenté de manière illustrative en figure la, le codage par transformée procède par découpage du signal temporel, succession d'échantillons x(n), en blocs comportant N échantillons. Sur chacun des blocs précités, après application d'une fenêtre de pondération spatio-temporelle d'amplitude, telle que la fenêtre du bloc m sur les échantillons 0 à N-1 ainsi que représenté en figure la, ces fenêtres étant réitérées avec un recouvrement sur N/2 échantillons, une transformée temps/fréquence est appliquée au bloc d'échantillons ainsi pondérés, pour obtenir un ensemble de coefficients y(k) lesquels sont alors codés puis transmis avec la réduction de débit recherchée.

Au décodage, une transformation inverse est appliquée aux coefficients reçus y'(k), ce qui permet de régénérer les échantillons d'origine x'(n) en temps réel, au temps de traitement codage-décodage, temps de transmission près. On notera toutefois que plusieurs types de transformées fréquentielles peuvent être utilisées, la transformée TCDM permettant cependant d'obtenir la réduction de débit la plus importante. Pour une description plus détaillée de ce type de traitement, on pourra se reporter par exemple aux publications de Johnston "Transform Coding of Audio Signals Using Perceptual Noise Criteria" IEEE Journal on selected Areas in Communications, Vol. 6, No2, Février 1988, p. 314-323 et de Princen et Bradley "Adaptive Transform Coding incorporating Time Domain Aliasing Cancellation" Speech communication, Décembre 1987.

Dans les systèmes de codage par transformée fréquentielle, le bruit de codage résultant de la quantification des coefficients est réparti uniformément sur toute la durée du bloc d'échantillons.

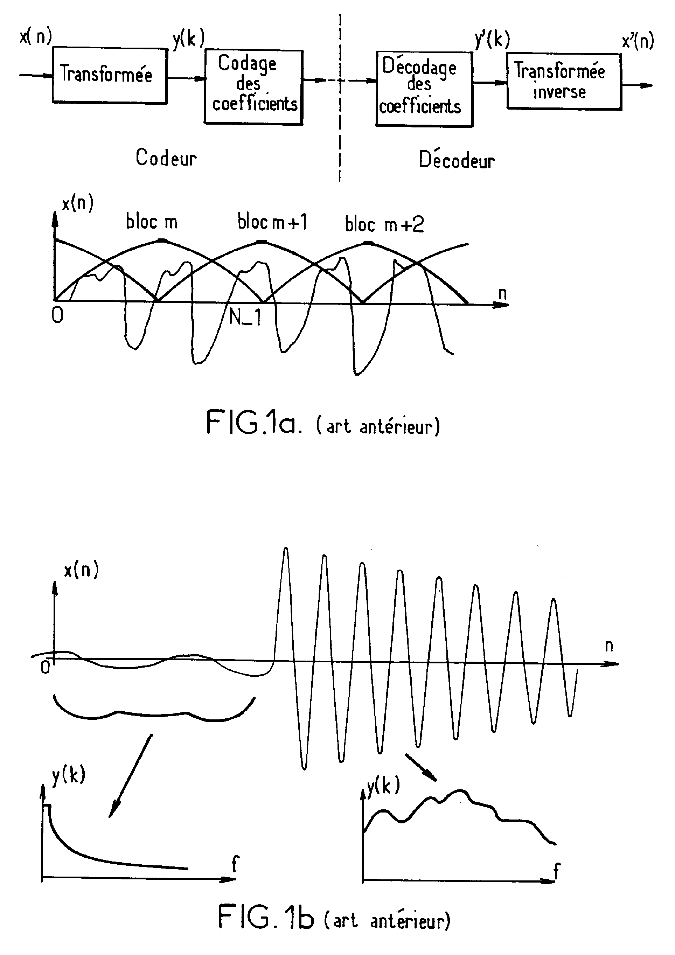

Lorsque ce bloc contient une non stationnarité, telle qu'une attaque brusque, ainsi que représenté en figure 1b, le spectre fréquentiel du signal, c'est-à-dire la distribution de l'amplitude des coefficients y(k) obtenus après transformée fréquentielle, en fonction de la fréquence f est à peu près plat.

En outre, les algorithmes de codage précités réalisent généralement une mise en forme spectrale du bruit (cf. publication de Johnston précitée) et, même relativement au bloc contenant une transition, telle que mentionnée précédemment, le spectre du bruit est à peu près plat et d'un niveau constant pour toute la durée du bloc.

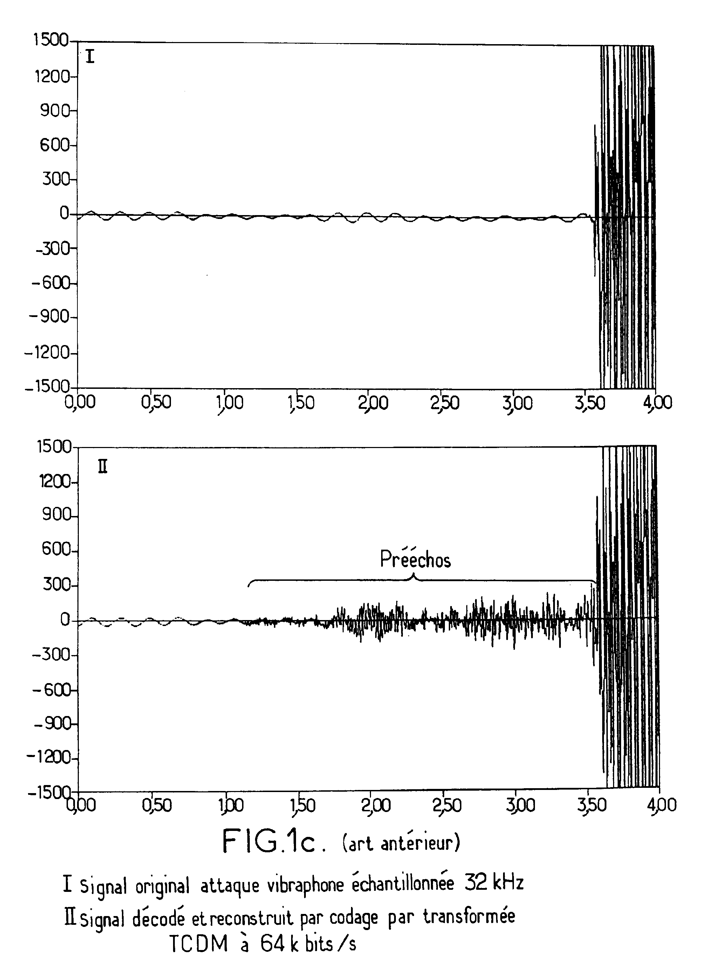

En conséquence, pour la partie précédant l'attaque, le spectre du bruit est bien supérieur à celui du signal. Ceci se traduit dans le domaine temporel, ainsi que représenté en figure 1c et 1d relatives à un signal original x(n) d'une attaque vibraphone respectivement à un signal correspondant décodé puis soumis à transformée inverse x'(n), par l'apparition d'une dégradation très importante appelée préécho.

En outre, lorsque le système de codage utilise la transformée TCDM, les deux blocs précédant la transition sont, du fait du recouvrement de N/2 échantillons entre fenêtres successives, affectés par le phénomène de prééchos.

Différentes méthodes de traitement ont été proposées pour réduire ou éliminer le phénomène de prééchos.

Parmi celles-ci, on peut citer la méthode préconisée par Schroeder décrite dans l'article intitulé "Stereo Coding with CD quality" International Conference on Consumer Electronics, Chicago 1987, et par Sugiyama décrite dans l'article "Adaptive Transform Coding with an adaptive Block Size", Proceedings of ICASSP 90, Albuquerque pp 1093-1096. Dans la méthode précitée, un facteur d'échelle est appliqué au bloc d'échantillons avant la transformation, de façon à réduire la différence de niveau avant et après la transition engendrée par l'attaque. L'application des facteurs d'échelle inverses au décodage permet de réduire le niveau de bruit dans les zones de faible énergie et donc l'amplitude, d'où la diminution correspondante du phénomène de préécho.

Cependant, une telle méthode ne peut être valablement utilisée lorsque la transformée fréquentielle est une transformée TCDM, une reconstitution parfaite du signal, en l'absence de codage, ne pouvant être effectuée, du fait de la présence même des facteurs d'échelle.

On peut en outre citer le procédé décrit par le document DE-A-3 806 416 au nom de Fraunhofer Gesellschaft. Dans ce document, le procédé d'élimination des prééchos est réalisé par la mise à zéro de coefficients de transformée, le signal original étant assimilé à un signal de type passe-bas. Dans un tel procédé, si le signal original est concentré dans les hautes fréquences et si le bruit est plutôt basse-fréquence, l'élimination efficace du bruit ne peut être obtenue. De même, la présence d'un bruit de préécho aux fréquences inférieures à celles du signal original ne peut être éliminée. Enfin, le mode opératoire du filtrage réalisé est susceptible d'entraîner l'existence de parasites, du type phénomènes de Gibbs, sur le signal reconstruit.

La présente invention a pour objet la mise en oeuvre d'un procédé et d'un système de traitement des prééchos d'un signal audio-numérique codé par transformée TCDM dans lesquels les prééchos sont sensiblement supprimés.

Un autre objet de la présente invention est la mise en oeuvre d'un procédé et d'un système de traitement des prééchos d'un signal audio-numérique codé par transformée TCDM dans lesquels aucune modification des niveaux de signal, avant ou après attaque, n'étant effectuée, une reconstitution quasi-parfaite du signal après décodage est ainsi obtenue.

Le procédé de traitement des prééchos d'un signal audio-numérique codé par transformée fréquentielle, objet de la présente invention, est remarquable en ce qu'il consiste, après codage de ce signal x(n) par tranformée fréquentielle en coefficients y(k), sur des fenêtres de pondération formées sur des blocs d'échantillons comportant N échantillons x(n) successifs, à effectuer au décodage des coefficients de transformée y(k), un filtrage optimal de façon à réduire, lors de la présence d'une transition ou variation d'amplitude du signal, le bruit additif résultant lors du codage de la quantification des coefficients de transformée.

Le système de traitement des prééchos de filtrage d'un signal audio-numérique codé par transformée fréquentielle, objet de la présente invention, ce système comportant, d'une part, disposés en cascade au niveau du codeur un module de lecture des échantillons x(n) de signal audio-numérique constituant ces derniers en blocs de N échantillons, un module de calcul de la transformée TCDM délivrant, à partir desdits blocs d'échantillons, des coefficients de transformée y(k) correspondants et un module de codage par quantification de ces coefficients en vue de leur transmission par l'intermédiaire d'un canal de transmission, et, d'autre part, disposés en cascade au niveau du décodeur, en réception du canal de transmission, un module de décodage des coefficients y(k) et un module de calcul de la transformée inverse TCDM$^{-1}$, ces modules constituant le décodeur et délivrant un signal décodé bruité x'(n), est remarquable en ce qu'il comporte en outre, d'une part, au niveau du codeur, un module de détection de transitions repérées par le rang N-q de la transition dans le bloc courant considéré, un module d'extraction, à partir des blocs d'échantillons x(n), des paramètres d'énergie $\sigma^2 x(n)$ de l'échantillon x(n) ou d'un groupe d'échantillons successifs du signal d'origine, un module de codage, à partir des paramètres d'énergie $\sigma^2 x(n)$ de l'échantillon x(n) ou du groupe d'échantillons du bloc d'échantillons, permettant la transmission codée des paramètres d'énergie $\sigma^2 x(n)$, et d'un signal indicateur de la présence d'une transition dans le bloc d'échantillons considéré, et, d'autre part, au niveau du décodeur, un module de reconstitution de paramètres d'énergie $\sigma^2 x(n)$ transmis, un module d'extraction des paramètres de filtrage a1, a2 à partir des échantillons x(n) du bloc précédent b-1 et d'évaluation des énergies du bruit de codage $\sigma^2 b(n)$ et du bruit $\sigma^2 w(n)$ pour l'échantillon de rang n considéré, un module de filtrage de Kalman recevant en entrée de filtrage le signal décodé bruité x'(n) et en entrée de commande lesdits paramètres de filtrage a1, a2 et l'évaluation des énergies du bruit de codage $\sigma^2 w(n)$, ledit module de filtrage délivrant en sortie le signal décodé filtré xr(n).

Le procédé et le système objets de la présente invention trouvent application à la transmission de signaux audio-numériques, de qualité haute fidélité, à la transmission, au codage, au décodage de signaux audio-numériques, à toutes les applications de la transmission de signaux audio-numériques, telles que le réseau numérique à intégration de services RNIS.

Le procédé et le système objet de l'invention seront mieux compris à la lecture de la description et à l'observation des dessins ci-après dans lesquels, outre les figures 1a à 1c relatives à l'art antérieur,

- la figure 2 représente un schéma illustratif de la mise en oeuvre du procédé objet de l'invention,
- la figure 3a représente un mode de réalisation du système selon l'invention au niveau du codeur des échantillons par transformée TCDM,
- la figure 3b représente un mode de réalisation du système selon l'invention au niveau du décodeur des échantillons codés transmis par transformée inverse TCDM$^{-1}$,
- la figure 4a représente un détail de réalisation des circuits d'extraction des paramètres de filtrage optimal, filtrage de KALMAN, au niveau du décodeur tel que représenté en figure 3b,
- la figure 4b représente un détail de réalisation des circuits d'estimation des paramètres d'énergie des échantillons audio-numériques x(n) au niveau du codeur, tel que représenté en figure 3a, et
- la figure 5 représente un chronogramme d'échantillons représentatifs d'un signal d'attaque de guitare échantillonné à 32kHz, d'un signal correspondant codé par transformée TCDM sans traitement des prééchos avec un débit de transmission de 64kbits/s et d'un signal correspondant codé avec traitement des prééchos au moyen du procédé et du système objets de la présente invention.

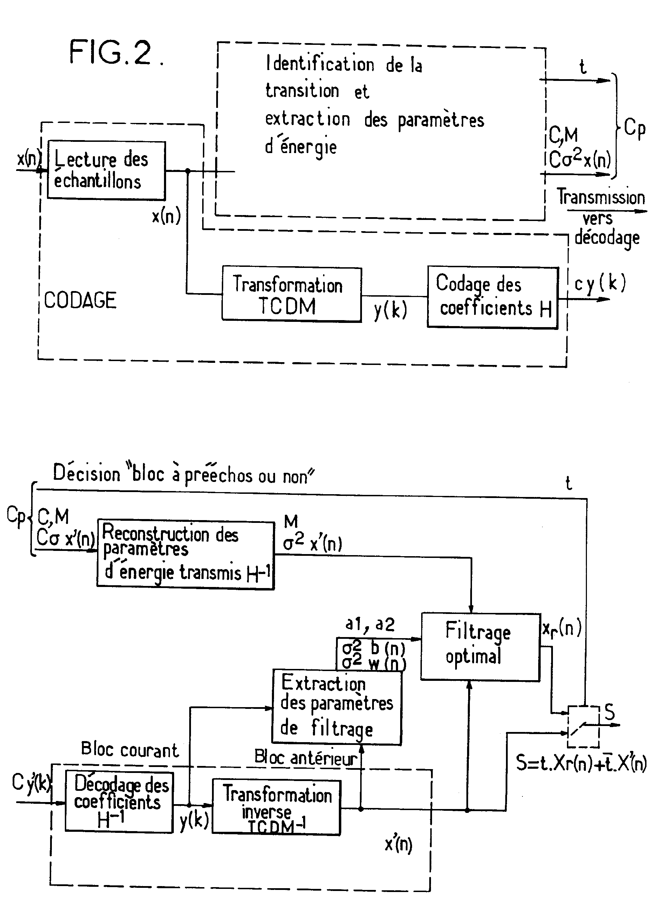

Une description plus détaillée de la mise en oeuvre du procédé de traitement des prééchos d'un signal audionumérique, codé de manière non limitative par transformée TCDM, conformément à l'objet de la présente invention sera donnée en liaison avec la figure 2. D'autres types de transformée fréquentielle peuvent cependant être utilisés, sans sortir du cadre de l'objet de la présente invention.

De manière classique, le procédé comprend des étapes de codage du signal audio-numérique x(n), ces échantillons étant, par un processus de lecture des échantillons conformés en bloc, notés x(n), ces blocs comportant par exemple N échantillons successifs, chaque bloc étant soumis à une fenêtre de pondération formée sur ces -blocs, ainsi que représenté par exemple en figure la. Les blocs précités sont ensuite soumis à un traitement par transformée TCDM, cette transformation délivrant les coefficients de transformée y(k). Les coefficients de transformée précités sont ensuite soumis à un processus de codage noté H, ce processus de codage délivrant des coefficients de transformée codés Cy(k) destinés à être transmis vers et en vue d'un processus de décodage.

Ainsi qu'on l'observera sur la figure 2, le procédé objet de la présente invention consiste à effectuer, au décodage des coefficients de transformée y(k), ce processus de décodage étant noté $H^{-1}$ au niveau du décodage proprement dit, et plus particulièrement suite à un processus de transformation inverse noté $TCDM^{-1}$ appliqué aux coefficients de transformée y(k) pour obtenir les échantillons x'(n) de rang n du signal décodé bruité, un filtrage optimal de ces échantillons du signal décodé bruité de façon à réduire lors de la présence d'une transition d'amplitude du signal audio-numérique le bruit additif résultant lors du codage de la quantification des coefficients de transformée.

De manière générale, on notera que la présence des prééchos au niveau du signal audio-numérique codé est en fait due à la dégradation du signal précédant la transition par introduction d'un bruit additif b(n) résultant de la quantification des coefficients de transformée y(k).

Ainsi, le traitement et la réduction de ce phénomène, conformément à l'objet du procédé selon la présente invention, est assimilable à un problème de débruitage lequel peut être conduit au moyen d'un filtrage optimal du signal audio-numérique décodé.

Ainsi qu'on l'a représenté en figure 2, le procédé objet de la présente invention implique de manière générale au niveau du codage un processus d'identification de la transition. Une telle identification peut être effectuée de manière non limitative par la détection d'une telle transition dans le bloc courant considéré, par la création par exemple d'une variable t représentative de l'existence ou de la non existence d'une telle transition dans le bloc précité. En outre, et de manière avantageuse non limitative, l'identification de la transition dans le bloc courant considéré pourra être réalisée par la discrimination de la position de la transition dans le bloc précité, c'est-à-dire en fait de l'abscisse M de l'échantillon représentatif de la première occurence de cette transition. On notera enfin que, outre l'identification de la transition dans le bloc considéré, le procédé objet de la présente invention implique également l'évaluation d'un paramètre d'énergie de chacun des échantillons x(n), ce paramètre d'énergie pour chacun des échantillons x(n) du signal audio-numérique précité étant noté $\sigma^2 x(n)$.

Bien entendu, l'ensemble des paramètres précités, paramètres d'identification de la transition, est alors transmis au décodage sous forme du paramètre t de présence ou d'absence de transition précité et du paramètre noté C,M lesquels représentent les paramètres codés de l'abscisse dans le bloc de la transition ainsi que d'un paramètre $C\sigma^2 x(n)$, lequel représente le paramètre d'énergie codé pour chaque échantillon x(n) du signal audio-numérique, l'ensemble des paramètres précités désignés par la référence Cp étant alors transmis vers le processus de décodage conjointement avec les coefficients de transformée codés notés Cy(k).

Une mise en oeuvre particulièrement avantageuse du procédé objet de l'invention peut être réalisée compte tenu du fait que le bruit additif b(n) est non stationnaire. En effet, l'énergie du bruit précité est plus forte pour n proche de la transition dans le bloc considéré que pour les échantillons situés en début du bloc.

Conformément à la remarque précitée, une mise en oeuvre particulièrement avantageuse du procédé objet de la présente invention consiste à réaliser le filtrage optimal précédemment mentionné sous la forme d'un filtrage de KALMAN. Le filtrage de KALMAN effectué au décodage permet alors, conformément au procédé de la présente invention, d'obtenir la réduction du phénomène des prééchos de manière particulièrement satisfaisante, ainsi qu'il sera décrit ci-après dans la description.

D'une manière générale, on rappellera que le filtrage de KALMAN suppose une modélisation de l'expression des signaux audio-numériques sous forme d'une équation d'état et d'une équation d'observation.

Le modèle d'état est associé au signal original x(n) tandis que l'équation d'observation décrit le signal décodé x'(n) bruité, c'est-à-dire affecté des prééchos.

L'équation d'état peut être définie sous forme auto-régressive d'ordre p. La valeur de p doit être choisie de façon à assurer un compromis entre une modélisation suffisamment exacte de la suite des échantillons du signal audio-numérique x(n) et un volume et une charge de calcul limité pour assurer un traitement compatible en temps réel. Pour une description plus détaillée de ce type de définition auto-régressive on pourra se reporter à la publication de Jayant et Noll intitulée "Digital Coding of Waweforms" 1984 Prentice Hall Signal Processing series.

Les équations matricielles du filtrage sont données par les relations :

$$X(n) = A.X(n - 1) + W(n)$$

$$x'(n) = C.X(n) + b(n)$$

avec

$$X(n) = \begin{bmatrix} x(n) \\ x(n-1) \\ x(n-2) \\ ..... \\ x(n-p) \end{bmatrix} \quad C=[1,0,0...0] \quad A=\begin{bmatrix} a1 & a2 & ..... & ap \\ 1 & 0 & 0 & 0 \\ 0 & 1 & 0 & 0 \\ . & 0 & 1 & 0 \\ . & . & . & . \\ . & . & . & . \end{bmatrix}$$

$x'(n)$ et $b(n)$ étant des scalaires.

Les équations générales du filtre s'écrivent :

* estimation: $Xr(n)= A.Xr(n-1)+ K(n)( x'(n) - C.A.Xr(n-1) )$
* calcul du gain : $K(n) = P1(n).C^T.[C.P1(n).C^T + \sigma_b^2 (n)]^{-1}$
* matrice de l'erreur de prédiction: $P1(n)=A.P(n-1).A^T+Q(n)$ avec

$$Q(n) = \begin{bmatrix} \sigma^2 w(n) & 0...0 \\ 0 & 0 & 0 \\ 0 & . & 0 \\ . & . & . \\ . & . & . \end{bmatrix}$$

* matrice de l'erreur d'estimation: $P(n)=P1(n)-K(n).C.P1(n)$

A titre d'exemple non limitatif, on considérera comme adapté pour la mise en oeuvre du procédé objet de la présente invention une valeur $p = 2$.

Dans ces conditions, l'équation d'état définie sous forme régressive d'ordre 2 s'écrit :

$$x(n) = a1.x(n - 1) + a2.x(n - 2) + w(n) \quad (1)$$

Dans la relation précitée, a1 et a2 désignent les coefficients de prédiction du filtre et $w(n)$ désigne l'amplitude du bruit d'innovation pour l'échantillon $x(n)$ de rang n considéré.

En outre, l'équation ou relation d'observation s'écrit sous forme scalaire :

$$x'(n) = x(n) + b(n) \quad (2)$$

Dans la relation précitée, $x(n)$ désigne bien entendu le signal audio-numérique original, c'est-à-dire l'échantillon d'ordre n courant considéré, $b(n)$ désigne l'amplitude du bruit de codage ou préécho pour ce même échantillon et $x'(n)$ désigne l'échantillon de rang n du signal décodé bruité, c'est-à-dire l'échantillon obtenu au décodage, ainsi que représenté en figure 2 après transformation inverse $TCDM^{-1}$.

Les équations du filtrage de KALMAN sont connues de l'état de la technique et compte tenu de la modélisation précédemment décrite, l'échantillon de rang n du signal décodé filtré, c'est-à-dire obtenu après filtrage optimal par filtrage de KALMAN est donné par la relation :

$$xr(n) = a1.(1 - K1).xr(n - 1) + a2(1 - K1).xr(n - 2) + K1.x'(n) \quad (3)$$
$$xr(n - 1) = xr(n - 1) + K2( x'(n) - (a1.xr(n - 1) + a2.xr(n - 2)) )$$

Dans la relation précitée, K1, K2 désignent la valeur de gain du filtre vérifiant la relation :

$$K1 = P1(1)/(P1(1) + s^2b(n)) \quad (4)$$
$$K2 = P1(3)/(P1(1) + s^2b(n)) \quad (5)$$

relations dans lesquelles les coefficients P1(1) et P1(3) sont donnés par la matrice de l'erreur de prédiction et par la matrice de l'erreur d'estimation du filtrage de KALMAN.

On rappellera pour mémoire que la matrice de l'erreur de prédiction est donnée par les relations :

$$P1(1) = a1^2.P(1) + a1a2(P(2) + P(3)) + a2^2.P(4) + \sigma w^2(n) \quad (6)$$
$$P1(2) = a1.P(1) + a2.P(3) \quad (7)$$
$$P1(3) = a1.P(1) + a2.P(2) \quad (8)$$
$$P1(4) = P(1) \quad (9)$$

En outre, la matrice de l'erreur d'estimation est donnée par les relations :

$$P(1) = (1 - K1).P1(1) \quad (10)$$
$$P(2) = (1 - K1).P1(2) \quad (11)$$
$$P(3) = P1(3) - K2.P1(1) \quad (12)$$
$$P(4) = P1(4) - K2.P1(2) \quad (13)$$

Les équations précitées sont calculées pour chaque valeur de n pour n compris, dans le bloc courant considéré, entre zéro et M-1, où M-1 est le numéro de l'échantillon immédiatement antérieur à la transition correspondant à l'échantillon d'ordre M, échantillon par exemple pour lequel une variation d'amplitude est supérieure à un rapport 4 par exemple.

On notera que dans le cas d'un codage par transformée TCDM les équations précitées doivent être appliquées aux deux blocs en recouvrement dans lesquels la transition est présente, c'est-à-dire les deux blocs en recouvrement correspondants.

On notera que dans les relations précitées, $\sigma^2 b(n)$ désigne l'énergie du bruit de codage et $\sigma^2 w(n)$ l'énergie du bruit d'innovation $w(n)$ pour l'échantillon $x(n)$ de rang n considéré.

On notera que les équations précitées sont établies dans l'hypothèse où $b(n)$ est considéré comme un bruit blanc indépendant de $x(n)$, ces conditions d'application étant en général vérifiées. En effet, lors de l'attaque, c'est-à-dire de l'apparition de la transition, le spectre à court terme résultant de la transformée par TCDM est sensiblement plat, il en est de même pour celui du bruit. D'autre part, on remarquera que ce bruit dépend largement de la portion la plus énergétique du signal, c'est-à-dire celle située après la transition, et par conséquent le bruit $b(n)$ est généralement décorrellé du signal $x(n)$ précédant l'attaque proprement dite.

Ainsi, conformément au procédé objet de la présente invention telle que représenté en figure 2, dans le cas où le filtrage optimal est un filtrage de KALMAN, ce procédé consiste lors du processus de codage à déterminer, d'une part, l'énergie $\sigma^2 x(n)$ de l'échantillon $x(n)$ du signal original et, d'autre part, l'existence d'une transition au niveau d'au moins un échantillon $x(N-q)$ de rang N-q d'un bloc courant déterminé, avec :

$$N - q = M \quad (14)$$

Le procédé selon l'invention consiste alors, lors du processus de codage, à transmettre au niveau décodage la valeur des paramètres d'énergie précités $\sigma^2 x(n)$ et d'existence de la transition ainsi que décrit précédemment.

Puis, le procédé objet de la présente invention consiste lors du processus de décodage à estimer les paramètres de filtrage, c'est-à-dire les coefficients de prédiction a1, a2 du filtrage à partir des échantillons du bloc b-1 précédant, conformément aux relations précédemment données dans la description. De même, les énergies de bruit de codage $\sigma^2 b(n)$ et du bruit $\sigma^2 w(n)$ pour l'échantillon de rang n considéré sont évaluées ce qui permet d'assurer, au niveau du décodage, le filtrage adaptatif de type filtrage de KALMAN du signal décodé bruité $x'(n)$ pour reconstituer le signal décodé filtré dans lequel les prééchos sont sensiblement supprimés.

De manière symbolique et conformément au procédé objet de la présente invention le signal S obtenu après décodage est donné par la relation logique :

$$S = t.xr(n) + \bar{t}.x'(n) \quad (15)$$

On comprendra bien sûr que dans la relation précitée, t prend la valeur 0 ou 1 en fonction de l'absence respectivement de la présence d'une transition pour le bloc courant considéré.

On comprendra que d'une manière générale, afin d'assurer une mise en oeuvre efficace du procédé objet de l'invention, certains paramètres nécessaires au filtrage peuvent être estimés au niveau du décodage alors que les paramètres destinés à suivre la non stationnarité du signal audio-numérique original $x(n)$ doivent être évalués au niveau du codage puis transmis afin d'assurer le décodage et le filtrage optimal précédemment mentionné.

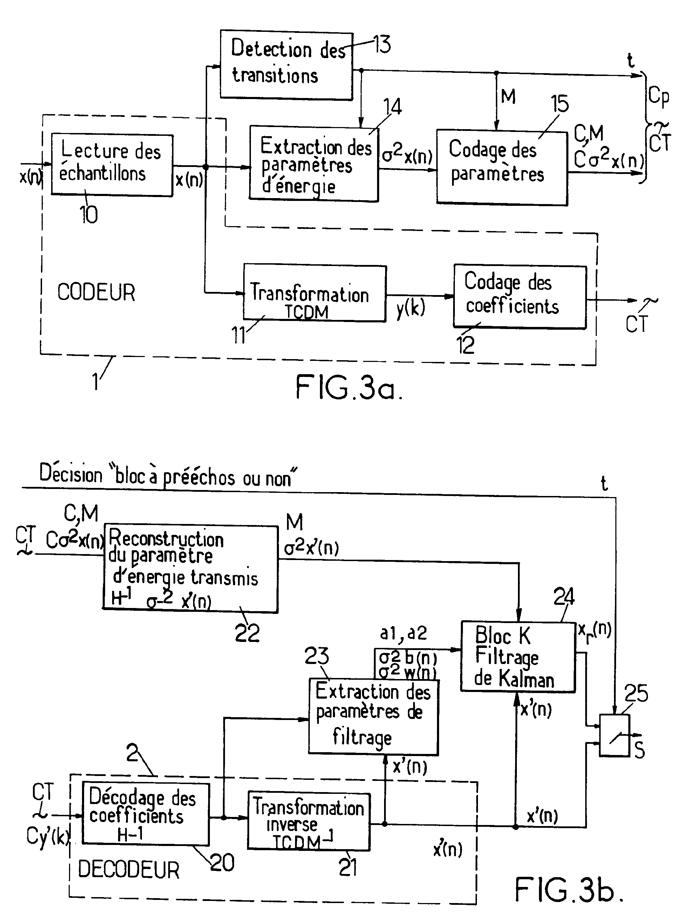

Une description plus détaillée d'un système de traitement des prééchos d'un signal audio-numérique codé par transformée fréquentielle conformément au procédé objet de la présente invention sera donné en liaison avec les figures 3a représentant plus particulièrement un codeur et 3b représentant au contraire un décodeur constitutif du système selon l'invention.

Bien entendu, les figures 3a et 3b sont représentées sous forme de schémas blocs, les différents schémas blocs permettant de réaliser les étapes du procédé objet de la présente invention tel que réalisé en figure 2.

En conséquence, ainsi qu'on l'a représenté en figure 3a par exemple, le système comporte, d'une part, disposé en cascade au niveau du codeur 1, un module 10 de lecture des échantillons $x(n)$ de signal audio-numérique constituant ces derniers en bloc de N échantillons, un module 11 de calcul de la transformée TCDM délivrant à partir des blocs d'échantillons les coefficients de transformée $y(k)$ correspondants et un module 12 de codage par quantification de ces coefficients en vue de leur transmission par l'intermédiaire d'un canal de transmission numérique noté CT sur la figure 3a. Le canal de transmission numérique CT ne sera pas décrit en détail car il correspond à un canal de transmission de type classique.

En outre, ainsi qu'on l'a représenté en figure 3b, le système selon l'invention comporte, d'autre part, disposé en cascade au niveau du décodeur 2 et en réception du canal de transmission CT précité un module 20 de décodage des coefficients y(k) et un module 21 de calcul de la transformée inverse TCDM$^{-1}$, ces modules constituant le décodeur et délivrant un signal décodé bruité x'(n).

Conformément à l'objet de la présente invention, le système comporte en outre, au niveau du codeur 1, un module 13 de détection des transitions repérées par le rang N-q de la transition dans le bloc courant considéré et un module 14 d'extraction à partir des blocs d'échantillons x(n) des paramètres d'énergie $\sigma^2$x(n) de l'échantillon x(n) courant correspondant ou d'un groupe d'échantillons successifs du signal d'origine.

Enfin, un module 15 de codage est prévu à partir des paramètres d'énergie $\sigma^2$x(n) de l'échantillon x(n) où du groupe d'échantillons du bloc d'échantillons, ce module de codage permettant d'engendrer des codes correspondants C$\sigma^2$x(n) et C,M afin de permettre la transmission codée des paramètres précités et du signal indicateur t de la présence d'une transition dans le bloc courant par l'intermédiaire du canal de transmission CT.

En ce qui concerne le module 13 de détection des transitions précédemment mentionné, on indiquera simplement que celui-ci engendre l'indicateur t lequel prend par exemple la valeur 1 dans le cas d'un bloc comportant une transition, c'est-à-dire susceptible d'engendrer des prééchos, cet indicateur étant simplement codé sur un bit et transmis au décodeur. Le module 13 délivre également la position de la transition dans le bloc considéré, c'est-à-dire l'abscisse du point M précité. L'adresse de la transition, M est alors délivrée au module 15 de codage précédemment mentionné et codé par exemple sur log$_2$(N) bits où N est de la taille du bloc de transformée pour transmission sous la forme du code C,M précédemment mentionné.

On notera que la détection des attaques peut être réalisée par examen de la forme d'onde temporelle, par exemple comparaison de la valeur de l'amplitude de l'échantillon considéré à une valeur de seuil dans le rapport 4 précédemment mentionné, le module 13 de détection de transition recevant bien entendu les échantillons x(n) du bloc considéré.

D'autres solutions peuvent être envisagées par exemple comparaison du spectre à court terme du bloc considéré par rapport à celui calculé sur le bloc précédent.

Ainsi qu'on l'a en outre représenté en figure 3b, le système selon l'invention comprend au niveau décodeur 2 un module 22 de reconstitution des paramètres d'énergie transmis, ce module recevant à partir du canal de transmission CT les codes d'adresse de transition C,M et d'énergie C$\sigma^2$x(n) et délivre les paramètres correspondants d'adresse M et d'énergie $\sigma^2$x(n). On notera que le module 22 permet de reconstituer les paramètres indispensables au filtrage et qui sont inconnus au niveau du décodeur.

En outre, ainsi que représenté en figure 3b, un module 23 d'extraction des paramètres de filtrage a1, a2 est prévu avant de réaliser l'évaluation de ces paramètres à partir des échantillons x(n) du bloc d'échantillons précédent et d'évaluation des énergies du bruit de codage $\sigma^2$b(n) et du bruit $\sigma^2$w(n) pour l'échantillon de rang n considéré. On notera d'une manière générale que l'extraction des paramètres de filtrage précités peut être effectuée soit à partir du signal décodé bruité x'(n) soit des coefficients de transformée quantifiés y'(k) délivrés par le module 20 de décodage.

Enfin un module 20 de filtrage de KALMAN est prévu lequel reçoit en entrée de filtrage le signal décodé bruité x'(n) délivré par le module 21 de transformation inverse TCDM$^{-1}$, ce même module de filtrage 24 recevant en entrée de commande les paramètres de filtrage a1, a2 et d'évaluation des énergies du bruit de codage $\sigma^2$b(n) et du bruit $\sigma^2$w(n) délivré par le module 23 d'extraction des paramètres précités. En outre, le module 20 de filtrage reçoit les paramètres d'énergie reconstitués délivrés par le module 22 et d'adresse de la transition M. Le module 20 de filtrage délivre en sortie le signal décodé filtré xr(n).

De manière non limitative et selon un aspect avantageux du système objet de la présente invention tel que représenté en figure 3b, le décodeur comporte en sortie un interrupteur commandé 25 lequel reçoit, d'une part, sur une première entrée de commutation le signal décodé filtré xr(n) et sur une deuxième entrée de commutation le signal x'(n) délivré par le décodeur et plus particulièrement par le module de transformation inverse 21. En entrée de commande de commutation, l'interrupteur commandé 25 reçoit l'indicateur de présence de transition t. Le signal S délivré correspond à celui indiqué en liaison avec la figure 2.

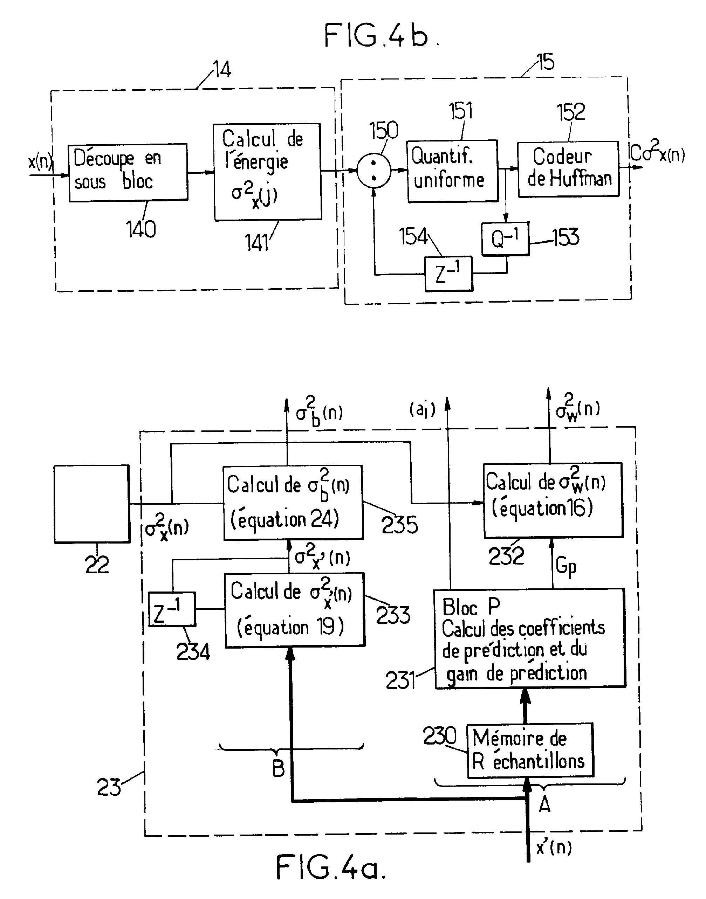

Une description plus détaillée du module 23 d'extraction des paramètres de filtrage a1, a2 et d'évaluation des énergies de bruit de codage $\sigma^2$b(n) et du bruit $\sigma^2$w(n) sera donnée en liaison avec la figure 4.

Ainsi que représenté sur la figure précitée, le module 23 d'extraction des paramètres de filtrage précité comporte en parallèle sur un port d'entrée des échantillons x'(n) du signal décodé bruité une première voie A de calcul des paramètres de filtrage a1, a2 et du bruit $\sigma^2$w(n) pour l'échantillon de rang n considéré et une deuxième voie B de calcul du bruit de codage $\sigma^2$b(n). Les paramètres de filtrage a1, a2 du bruit $\sigma^2$w(n) et du bruit de codage $\sigma^2$b(n) sont délivrés au module de filtrage de KALMAN 24.

La structure du module 23 d'extraction des paramètres de filtrage telle que représentée en figure 4a peut être justifiée de la façon ci-après.

L'équation d'état donnée par la relation (1) nécessite la connaissance des coefficients de prédiction ai, c'est-à-dire a1, a2, lorsque cette équation d'état est définie sous forme auto-régressive d'ordre 2.

Ces coefficients doivent par contre être calculés sur le signal non bruité. En supposant qu'avant l'apparition de la transition d'attaque le signal est stationnaire, alors les coefficients a1, a2 peuvent être estimés au niveau du décodeur à partir des échantillons reconstitués du bloc précédent puisque ces échantillons ne sont pas affectés par le phénomène de préécho.

Ainsi, la première voie A de calcul des paramètres de filtrage comporte une mémoire d'échantillon 230 recevant les échantillons bruités $x'(n)$ délivrés par le module 21 de transformation inverse. A chaque bloc à l'issue du décodage, les R derniers échantillons sont conservés en mémoire au niveau de la mémoire 230. Pour une taille de bloc N = 1024 par exemple, on peut prendre R = 256. Ces R échantillons servent d'entrée au dispositif de calcul des coefficients de prédiction. La première voie A comporte en conséquence un circuit 231 de calcul des coefficients de prédiction ai ou plus précisément a1, a2 et de gain de prédiction Gp. Les R échantillons mis en mémoire au niveau de la mémoire 230 servent d'entrée au dispositif de calcul des coefficients de prédiction si le bloc suivant est détecté comme étant un bloc à préécho, c'est-à-dire pour t=1.

Le circuit 231 de calcul peut par exemple être constitué par un circuit de calcul numérique permettant le calcul des coefficients précités au moyen d'un algorithme de Levinson. L'algorithme de Levinson précité ne sera pas décrit car cet algorithme est connu de l'état de la technique. Les coefficients de prédiction a1, a2 ou plus généralement ai constituent l'une des entrées du module de filtrage 24. Ces coefficients sont supposés constants sur la durée du préécho.

En outre, la première voie A comprend en cascade avec le circuit 231 de calcul des coefficients de prédiction et de gain de prédiction Gp un circuit 232 de calcul de la variance du bruit d'innovation $\sigma^2 w(n)$. Ce circuit reçoit d'une part la valeur reconstituée du paramètre d'énergie de l'échantillon $\sigma^2 x'(n)$ transmis délivré par le module 22 correspondant et le gain de prédiction Gp. La variance du bruit $\sigma^2 w(n)$ vérifie la relation donnée par le modèle auto-régressif :

$$\sigma w^2(n) = \sigma x^2(n)/G_p. \quad (16)$$

Dans cette relation $\sigma^2 x(n)$ est l'énergie du signal original audio-numérique non bruité, $G_p$ représentant le gain de prédiction associé au modèle auto-régressif.

On précise que le calcul du gain $G_p$ peut être effectué au niveau du circuit 231 à partir des coefficients de prédiction a1 et a2 ou plus généralement ai. Une méthode de calcul utilisable est décrite par Jayant et Noll dans l'ouvrage Digital Coding of Waveforms 1984, Prentice Hall Signal Processing Series page 263.

Ainsi qu'on l'a en outre représenté en figure 4a, la deuxième voie B comporte successivement connecté en cascade un circuit 233 de calcul du paramètre d'énergie $\sigma^2 x'(n)$ de l'échantillon $x'(n)$ bruité. Le circuit 233 de calcul est suivi d'un circuit 235 de calcul du paramètre de bruit de codage $\sigma^2 b(n)$ des échantillons.

L'énergie du bruit de codage $\sigma^2 b(n)$ peut être déduite des énergies des signaux non bruités d'origine $\sigma^2 x(n)$ et du signal bruité $\sigma^2 x'(n)$ du signal bruité $x'(n)$.

En effet, dans l'hypothèse d'une décorrélation totale entre le signal original et le bruit de codage b(n) on peut écrire :

$$\sigma^2 x'(n) = \sigma^2 x(n) + \sigma^2 b(n) \quad (17)$$
$$\sigma^2 b(n) = \sigma^2 x'(n) - \sigma^2 x(n) \quad (18)$$

On notera que les énergies des signaux audionumériques d'origine et bruités peuvent être évaluées de diverses manières.

Par exemple, l'énergie du signal bruit $\sigma^2 x'(n)$ peut être calculée au niveau du décodeur à l'aide d'une équation récursive de la forme :

$$\sigma^2 x'(n) = \alpha . \sigma^2 x'(n-1) + (1-\alpha).x'^2(n) \quad (19)$$

Dans cette équation a est une constante comprise entre 0 et 1 et peut par exemple être prise égale à 0,95. Dans ce but, au circuit de calcul 233 est associé un circuit de retard 234 lequel restitue la valeur $\sigma^2 x'(n-1)$ relative à l'échantillon d'ordre n-1 du signal bruité $x'(n-1)$. Bien entendu, le circuit 233 de calcul du paramètre d'énergie $\sigma^2 x'(n)$ permet alors de déterminer la valeur actuelle de l'énergie de l'échantillon bruité $\sigma^2 x'(n)$ selon la relation 19.

La valeur de l'énergie de l'échantillon non bruité $\sigma^2 x(n)$ est, on le rappelle, calculée au niveau du codeur, transmise au décodeur et délivrée par le circuit correspondant 22. On peut considérer $\sigma^2 x(n)$ constant sur toute la durée du préécho ce qui permet de ne transmettre ainsi qu'une seule valeur correspondante par bloc d'échantillons.

Cependant, ainsi qu'on le remarquera à l'observation de la figure 1c I par exemple, le signal précédant l'attaque, c'est-à-dire l'apparition de la transition, peut contenir des variations énergétiques relativement importantes dont le dispositif de filtrage précédemment décrit doit être informé.

Dans ce but, une description plus détaillée du module 14 d'extraction des paramètres d'énergie au niveau du codeur sera donnée en liaison avec la figure 4b.

Selon la figure précitée, le module 14 comprend un module 140 de découpe de chaque bloc b de N échantillons en sous blocs d'un nombre déterminé d'échantillons successifs. Ainsi, le module 140 effectue cette découpe en sous bloc de dimension L. La valeur du paramètre L peut être choisie de façon à ce que les variations locales d'énergie puissent être isolées dans un sous bloc. A titre d'exemple non limitatif pour une fréquence d'échantillonnage égale à 32kHz la valeur de L peut être prise égale à L = 128.

Le traitement des prééchos par filtrage est alors effectué sur R = E[M/L] sous blocs de L échantillons, où la notation E(.) signifie partie entière. On notera que les M-r.L derniers échantillons précédant la transition peuvent ne pas être filtrés. En effet, du fait des propriétés de masquage temporel et pour une valeur de L suffisamment faible, le bruit qui les affecte n'est pas audible. Une description des effets du masquage temporel plus détaillée pourra être trouvée dans l'ouvrage publié par Zwicker intitulé "Psycho-acoustique, l'oreille récepteur d'information" publié à Paris aux Editions MASSON en 1981.

Dans chacun des M/L sous-blocs, le paramètre d'énergie $\sigma^2 x(n)$ peut être calculé au moyen de la relation :

$$\sigma^2 x(j) = (1/L) . \sum_{l=j.L}^{(j+1)L-1} x^2(l) \qquad (20)$$

Dans cette relation j représente le numéro du sous bloc parmi l'ensemble des M/L sous blocs ainsi constitué, $0 \leqq j \leqq$ M/L-1.

Le calcul précité est effectué au moyen du module 141 de calcul de l'énergie $\sigma^2 x(j)$ lequel reçoit les différents sous blocs délivrés par le module 140 précédemment décrit.

L'ensemble $[\sigma x^2(j)]$ des paramètres d'énergie $\sigma^2 x(j)$ est codé et transmis au décodeur par l'intermédiaire du module de codage 15.

Selon le mode de réalisation de la figure 4b, le codage des paramètres d'énergie précités peut par exemple être réalisé conformément au mode de réalisation de cette figure par quantification des rapports successifs.

Dans ce but, le module de codage comporte avantageusement successivement un diviseur 150 recevant les paramètres d'énergie $\sigma^2 x(j)$ précédemment décrit, un quantificateur uniforme 151 et un codeur de Huffmann 152. La sortie du quantificateur uniforme 151 est en outre rebouclée sur une entrée du diviseur 150 par l'intermédiaire d'un circuit de quantification inverse 153 suivi d'un circuit de retard d'un échantillon 154.

On notera que le diviseur 150 délivre ainsi au quantificateur uniforme 151 les valeurs des rapports successifs e(j) donnés par la relation :

$$e(j) = \sigma^2 x(j)/\sigma^2 x(j-1) \qquad (21)$$

Ces rapports peuvent être quantifiés par le quantificateur uniforme précité constitué par un quantificateur à faible nombre de niveaux. Les mots de code en sortie du quantificateur uniforme 151 peuvent alors subir un codage par entropie par exemple, un codage de Huffmann au moyen du codeur 152.

D'autres techniques telles que la quantification vectorielle peuvent cependant être utilisées. Le module de codage 15 délivre alors le code $C\sigma^2 x(n)$ correspondant pour transmission par le canal de transmission CT précédemment décrit.

Au niveau du décodeur, en particulier au niveau du module 23 d'extraction des paramètres de filtrage a1, a2 tel que représenté en figure 4a, l'énergie du bruit de codage $\sigma^2 b(n)$ est donnée par la relation :

$$\sigma^2 b(n) = \sigma^2 x'(n) - \sigma^2 x'(j) \qquad (22)$$

Dans cette relation les indices j,n sont liés par l'équation :

$$j.L \leqq n \leqq (j+1).L - 1.$$

Dans la relation (22) précitée, on notera en particulier que $\sigma^2 x'(j)$ est la version quantifiée de $\sigma^2 x(j)$ au sous bloc j reçu au décodeur et $\sigma^2 x'(n)$ est estimé par l'équation (19) précédemment décrite.

Afin de disposer d'une estimation de bruit lissé délivré par le module 23, notamment à la jonction des sous blocs en n = j.L une équation récursive du même type que l'équation 19 peut être utilisée, la valeur de bruit lissé vérifiant la relation :

$$\sigma^2 b(n) = \beta.\sigma^2 b(n-1) + (1-\beta)(\sigma^2 x'(n) - \sigma^2 x'(j)) \qquad (23)$$

Dans cette relation β est une constante comprise entre zéro et un ayant pour valeur par exemple la valeur β = 0,85.

La première valeur $\sigma^2 x(0)$ permettant l'initialisation de la forme récursive donnée par la relation 20 doit être codée par rapport à une variable commune au décodeur 1 et au décodeur 2.

A titre d'exemple non limitatif, il peut s'agir de l'énergie du bloc précédant estimé par la somme des énergies des coefficients de transformée quantifiés y'(k). Dans une telle hypothèse le rapport e(0) vérifie la relation :

$$e(0) = \sigma^2 x(0)/\rho^2 x \qquad (24)$$

Dans la relation précitée

$$\rho_x{}^2 \; = \; \Sigma y'^2(k). \quad (25)$$

Dans la relation précédente, les termes $y'^2(k)$ sont les coefficients quantifiés du bloc précédent. En effet, d'après la relation de Parseval, $\rho^2{}_x = \sigma^2{}_x$ au bruit de codage près. Toutefois dans le cas d'un codeur utilisant la transformée TCDM la relation de Parseval n'est pas vérifiée mais du fait des particularités de cette transformée le terme $\rho^2{}_x$ peut être approximé par :

$$\rho^2{}_x \; = \; 4.\Sigma y'^2(k) \quad (26)$$

Le procédé et le système de la présente invention permettent d'obtenir des résultats particulièrement remarquables car ils permettent d'obtenir une forte réduction des prééchos.

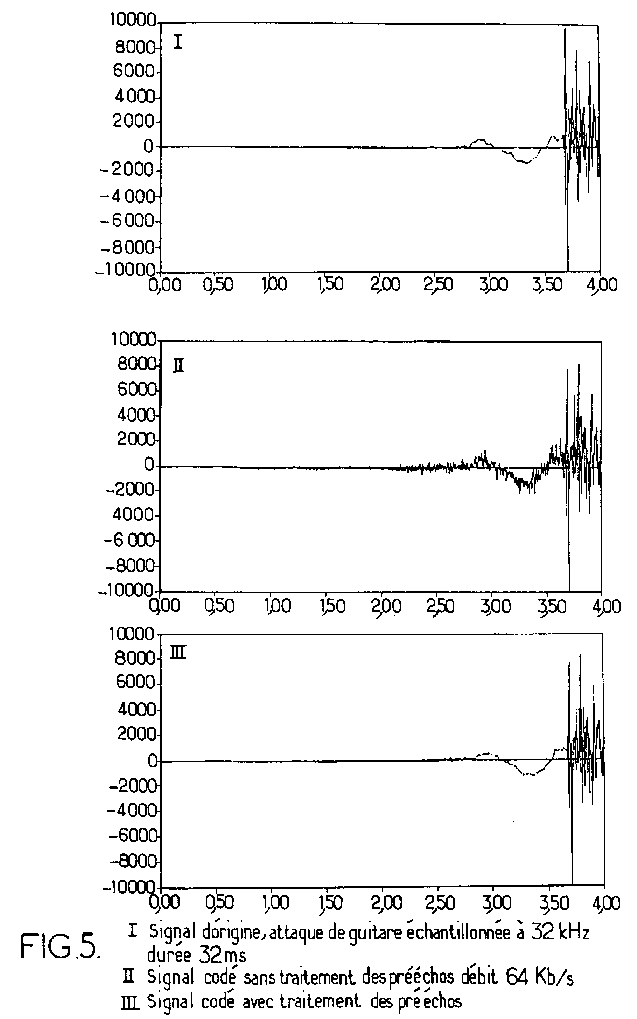

Sur la figure 5 on a représenté respectivement en I le signal d'origine d'une attaque de guitare échantillonné à 32 kHz sur une durée de 32 msec. L'axe des amplitudes est gradué en valeur relative d'amplitude ce qui permet de constater, au niveau des échantillons immédiatement antérieurs à la transition proprement dite, une forte variation d'amplitude par rapport aux échantillons du même bloc en début de celui-ci.

Au point II de cette même figure 5 on a représenté au contraire le signal codé sans traitement des prééchos, le codage étant effectué au moyen d'une transformée TCDM et la transmission étant effectuée avec un débit de 64kbits/s. Ainsi qu'on le notera à l'observation du point II de la figure 5 précité, le phénomène des prééchos est très apparent, dans la mesure où le bruit de préécho, sur les mêmes échantillons immédiatement antérieurs à la transition elle-même, présente une amplitude crête à crête sensiblement 4 à 5 fois supérieure à l'amplitude du niveau de bruit des échantillons présents en début de bloc correspondant.

Au point III de cette même figure 5 on a représenté le signal codé avec traitement des prééchos et l'on constate que le bruit de préécho a pratiquement disparu pour donner une signature de signal pratiquement semblable à celle du point I de cette même figure 5. Bien entendu sur les points I, II et III les axes sont gradués selon les mêmes unités en valeur relative de façon à donner une bonne appréciation de la réduction du niveau des prééchos ainsi obtenu.

Du fait du caractère adaptatif du procédé et du système objets de la présente invention la réduction du niveau des prééchos est particulièrement performante pour tout type de signal. L'amélioration de la qualité qui en résulte est particulièrement sensible surtout lorsque le codeur utilise une transformée par TCDM sans que pour cela il y ait un accroissement sensible du retard du système de codage. On comprendra en effet que le traitement, tant au niveau du codage qu'au niveau du décodage, est effectué en temps réel la transmission des échantillons débruités étant ainsi effectuée en temps réel au temps de transmission et de traitement d'un bloc près.

## Revendications

1. Procédé de traitement des prééchos d'un signal audio-numérique codé par transformée fréquentielle, dans lequel, après codage dudit signal par transformée fréquentielle en coefficient $y(k)$ sur des fenêtres de pondération formées sur des blocs d'échantillons $x(n)$ comportant N échantillons successifs, est effectué, au décodage des coefficients de transformée $y(k)$, un filtrage, de façon à réduire, lors de la présence d'une transition d'amplitude du signal, le bruit additif résultant lors du codage de la quantification des coefficients de transformée, caractérisé en ce que ledit filtrage est un filtrage optimal, du type filtrage de KALMAN.

2. Procédé selon la revendication 1, caractérisé en ce que le processus de filtrage de KALMAN étant défini à partir d'une équation d'état définie sous forme régressive d'ordre 2 de la forme :

$$x(n) \; = \; a1.x(n - 1) + a2.x(n - 2) + w(n)$$

où a1 et a2 désignent les coefficients de prédiction du filtre et $w(n)$ le bruit d'innovation pour l'échantillon $x(n)$ de rang n considéré et d'une relation d'observation de la forme :

$$x'(n) \; = \; x(n) + b(n)$$

où $b(n)$ désigne l'amplitude du bruit de codage ou préécho pour ce même échantillon $x(n)$, $x'(n)$ désignant l'échantillon de rang n du signal décodé bruité et l'échantillon de rang n du signal décodé filtré étant donné par la relation :

$$xr(n) \; = \; a1.(1 - K1).xr(n - 1) + a2.(1 - K1).xr(n - 2) + K1.x'(n)$$

où K1 désigne la valeur de gain du filtre vérifiant les relations :

$$K1 \; = \; P1(1)/[P1(1) + \sigma^2 b(n)]$$

$$K2 \; = \; P1(3)/[P1(1) + \sigma^2 b(n)]$$

les coefficients P1(1) et P1(3) étant donnés par la matrice de l'erreur de prédiction et par la matrice de l'erreur d'estimation du filtrage de KALMAN, $\sigma^2 b(n)$ désignant l'énergie du bruit de codage et $\sigma^2 w(n)$ désignant l'énergie du bruit d'innovation $w(n)$ pour l'échantillon $x(n)$ de rang n considéré, ledit procédé consiste :

lors du processus de codage,

- à déterminer, d'une part, l'énergie $\sigma^2x(n)$ de l'échantillon x(n) du signal original et, d'autre part, l'existence d'une transition au niveau d'au moins un échantillon x(N-q) de rang N-q d'un bloc courant déterminé, puis à transmettre au niveau décodage la valeur des paramètres d'énergie $\sigma^2x(n)$ et d'existence de la transition puis,

lors du processus de décodage,

- à estimer les paramètres de filtrage, coefficients de prédiction a1, a2 du filtrage à partir des échantillons du bloc précédent,
- à évaluer les énergies du bruit de codage $\sigma^2b(n)$ et du bruit $\sigma^2w(n)$ pour l'échantillon de rang n considéré, ce qui permet d'assurer, au niveau du décodage, le filtrage adaptatif du signal décodé bruité x'(n) pour reconstituer le signal décodé dans lequel les prééchos sont sensiblement supprimés.

3. Système de traitement des prééchos d'un signal audio-numérique codé par transformée fréquentielle, ce système comportant, d'une part, disposés en cascade au niveau du codeur (1), un module (10) de lecture des échantillons x(n) de signal audio-numérique constituant ces derniers en blocs de N échantillons, un module (11) de calcul de la transformée fréquentielle délivrant, à partir desdits blocs d'échantillons, des coefficients de transformée y(k) correspondants et un module (12) de codage par quantification de ces coefficients en vue de leur transmission par l'intermédiaire d'un canal de transmission numérique et, d'autre part, disposés en cascade au niveau du décodeur (2), en réception du canal de transmission, un module (20) de décodage des coefficients y(k) et un module (21) de calcul de la transformée fréquentielle inverse, ces modules constituant le décodeur et délivrant un signal décodé bruité x'(n), caractérisé en ce que ledit système comporte en outre, d'une part, au niveau du codeur (1),

- un module (13) de détection des transitions repérées par le rang N-q de la transition dans le bloc courant considéré,
- un module (14) d'extraction, à partir des échantillons x(n), des paramètres d'énergie $\sigma^2x(n)$ de l'échantillon x(n) ou d'un groupe d'échantillons successifs du signal d'origine,
- un module (15) de codage, à partir des paramètres d'énergie $\sigma^2x(n)$ de l'échantillon x(n) ou du groupe d'échantillons du bloc d'échantillons permettant la transmission codée des paramètres d'énergie $\sigma^2x(n)$ et d'un signal indicateur de la présence d'une transition dans le bloc d'échantillons considéré et, d'autre part,

au niveau du décodeur (2),

- un module (22) de reconstitution des paramètres d'énergie $\sigma^2x(n)$ transmis,
- un module (23) d'extraction des paramètres de filtrage a1, a2, à partir des échantillons x(n) du bloc précédent et d'évaluation des énergies du bruit d'innovation $\sigma^2w(n)$ et du bruit de codage $\sigma^2b(n)$ pour l'échantillon de rang n considéré,
- un module (24) de filtrage de KALMAN recevant en entrée de filtrage le signal décodé bruité x'(n) et en entrée de commande lesdits paramètres de filtrage a1, a2 et d'évaluation des énergies du bruit de codage $\sigma^2b(n)$ et du bruit d'innovation $\sigma^2w(n)$, ledit module (24) de filtrage délivrant en sortie le signal décodé filtré xr(n).

4. Système selon la revendication 3, caractérisé en ce qu'il comprend en outre un commutateur deux voies (25) dont une première voie commutée reçoit ledit signal décodé filtré xr(n) et dont une deuxième voie commutée reçoit ledit signal décodé bruité x'(n) délivré par le module (21) de transformation inverse, la voie de commande de commutation étant pilotée par ledit signal indicateur (t) de la présence d'une transition dans le bloc d'échantillons considéré.

5. Système selon la revendication 3 ou 4, caractérisé en ce que ledit module (14) d'extraction des paramètres d'énergie $\sigma^2x(n)$ des échantillons x(n) du signal comporte, disposés en cascade :

- un module (140) de découpe de chaque bloc de N échantillons en sous-blocs d'un nombre déterminé d'échantillons successifs,
- un module (141) de calcul de l'énergie $\sigma^2x(j)$ d'un échantillon ou d'un groupe d'échantillons du signal d'origine.

6. Système selon l'une des revendications 3 à 5, caractérisé en ce que le module de codage comporte :

- un quantificateur uniforme (151) délivrant, à partir des valeurs de paramètre, des mots de code,
- un circuit (152) de codage de Huffmann.

7. Système selon l'une des revendications 3 à 6, caractérisé en ce que ledit module (23) d'extraction des paramètres de filtrage a1, a2 et d'évaluation des énergies du bruit de codage $\sigma^2 b(n)$ et du bruit $\sigma^2 w(n)$ comporte, en parallèle sur un port d'entrée des échantillons x'(n) du signal décodé bruité,
   - une première voie (A) de calcul des paramètres de filtrage a1, a2 et de la variance du bruit d'innovation $\sigma^2 w(n)$ pour l'échantillon de rang n considéré,
   - une deuxième voie (B) de calcul de l'énergie du bruit de codage $\sigma^2 b(n)$, les paramètres de filtrage a1, a2, du bruit d'innovation $\sigma^2 w(n)$ et du bruit de codage $\sigma^2 b(n)$ étant délivrés au module de filtrage de KALMAN.

8. Système selon la revendication 7, caractérisé en ce que ladite première voie (A) comporte successivement, connectés en cascade :
   - une mémoire d'échantillons (230), recevant les échantillons bruités x'(n) délivrés par le module (21) de transformation inverse,
   - un circuit (231) de calcul des coefficients de prédiction (ai, a1, a2) et de gain de prédiction Gp,
   - un circuit (232) de calcul de la variance du bruit d'innovation d'échantillon $\sigma^2 w(n)$, ce circuit recevant, d'une part, la valeur reconstituée du paramètre d'énergie de l'échantillon $\sigma^2 x'(n)$ transmis délivrée par le module (22) correspondant, et, d'autre part, le gain de prédiction Gp, le bruit d'échantillon vérifiant la relation :

$$\sigma^2 w(n) \;=\; \frac{\sigma^2 x'(n)}{Gp}$$

9. Système selon la revendication 7, caractérisé en ce que ladite deuxième voie (B) comporte successivement, connectés en cascade :
   - un circuit (233) de calcul du paramètre d'énergie $\sigma^2 x'(n)$ de l'échantillon x'(n) bruité, ce paramètre d'énergie vérifiant une relation récursive de la forme :
   $$\sigma^2 x'(n) \;=\; \alpha.\sigma^2 x'(n-1) + (1-\alpha).x'^2(n),$$
   où $\alpha$ est une constante de valeur comprise entre zéro et un,
   - un circuit (235) de calcul du paramètre de bruit de codage $\sigma^2 b(n)$ des échantillons, ce paramètre de bruit vérifiant une relation de la forme :
   $$\sigma^2 b(n) \;=\; \sigma^2 x'(n) - \sigma^2 x(n).$$


**Patentansprüche**

1. Verfahren zur Verarbeitung von Vorechos eines durch Frequenztransformierte kodierten, digitalen Audiosignals, bei welchem, nach Kodierung des Signals durch Frequenztransformierte zu Koeffizienten y(k) auf Gewichtungsfenstern, welche auf N aufeinanderfolgende Abtastwerte umfassenden Blöcken von Abtastwerten x(n) gebildet sind, bei Dekodierung der Koeffizienten y(k) der Transformierten eine Filterung derart durchgeführt wird, daß bei Anwesenheit eines Übergangs der Amplitude des Signals das bei der Kodierung der Quantifizierung der Koeffizienten der Transformierten resultierende zusätzliche Rauschen verringert wird, dadurch gekennzeichnet, daß die Filterung eine optimale Filterung vom KALMAN-Filterungstyp ist.

2. Verfahren nach Anspruch 1, dadurch gekennzeichnet, daß der KALMAN-Filterungsvorgang ausgehend von einer Zustandsgleichung definiert ist, welche in regressiver Form der Ordnung 2 in der Form:
   $$x(n) \;=\; a1.x(n-1) + a2.x(n-2) + w(n)$$
   definiert ist, wobei a1 und a2 die Koeffizienten der Voraussage des Filters und w(n) das Innovationsrauschen für den betrachteten Abtastwert x(n) vom Rang n bezeichnen, und eine Beobachtungsbeziehung der Form:
   $$x'(n) \;=\; x(n) + b(n),$$
   wobei b(n) die Amplitude des Rauschens der Kodierung oder des Vorechos für diesen gleichen Abtastwert x(n) bezeichnet, wobei x'(n) den Abtastwert vom Rang n des verrauschten, dekodierten Signals bezeichnet, und der Abtastwert vom Rang n des gefilterten, dekodierten Signals gegeben ist durch die Beziehung:
   $$xr(n) \;=\; a1.(1-K1).xr(n-1) + a2.(1-K1).xr(n-2) + K1.x'(n),$$
   wobei K1 den Wert des Verstärkungsgrads des Filters bezeichnet und die Beziehungen:
   $$K1 \;=\; P1(1)/[P1(1) + \sigma^2 b(n)]$$
   $$K2 \;=\; P1(3)/[P1(1) + \sigma^2 b(n)]$$
   erfüllt, wobei die Koeffizienten P1(1) und P1(3) durch die Matrix der Voraussagefehler und durch die Matrix der Abschätzungsfehler der KALMAN-Filterung gegeben sind, wobei $\sigma^2 b(n)$ die Energie des Kodierungsrauschens und $\sigma^2 w(n)$ die Energie des Innovationsrauschens $w(n)$ für den betrachteten Abtastwert $x(n)$ vom Rang n bezeichnen, wobei das Verfahren umfaßt:

bei dem Kodierungsvorgang,

- die Bestimmung einerseits der Energie $\sigma^2 x(n)$ des Abtastwerts $x(n)$ des Ursprungssignals und andererseits der Anwesenheit eines Übergangs auf Ebene wenigstens eines Abtastwerts $x(N-q)$ vom Rang N-q eines bestimmten, laufenden Blocks, dann die Übertragung auf Dekodierungsebene des Werts der Parameter der Energie $\sigma^2 x(n)$ und der Anwesenheit des Übergangs und dann

bei dem Dekodierungsvorgang

- die Abschätzung der Filterungsparameter, Voraussagekoeffizienten a1, a2 der Filterung aus den Abtastwerten des vorhergehenden Blocks,
- die Auswertung der Energien $\sigma^2 b(n)$ des Kodierungsrauschens und $\sigma^2 w(n)$ des Rauschens für den betrachteten Abtastwert vom Rang n, wodurch auf Dekodierungsebene die adaptive Filterung des verrauschten, dekodierten Signals $x'(n)$ ermöglicht wird, um das dekodierte Signal zu rekonstruieren, in welchem die Vorechos im wesentlichen beseitigt sind.

3. Einrichtung zur Verarbeitung von Vorechos eines durch Frequenztransformierte kodierten digitalen Audiosignals, diese Einrichtung umfassend einerseits kaskadenartig angeordnet auf Ebene des Kodierers (1) ein Modul (10) zum Lesen von Abtastwerten $x(n)$ des digitalen Audiosignals, welches diese letzteren in Blöcke von N Abtastwerten bringt, ein Modul (11) zur Berechnung der Frequenztransformierten, welches ausgehend von diesen Abtastwertblöcken die entsprechenden Koeffizienten $y(k)$ der Transformierten liefert, und ein Modul (12) zur Kodierung durch Quantifizierung dieser Koeffizienten im Hinblick auf ihre Übertragung mit Hilfe eines digitalen Übertragungskanals und andererseits kaskadenartig auf Ebene des Dekodierers (2) angeordnet, den Übertragungskanal empfangend, ein Modul (20) zur Dekodierung der Koeffizienten $y(k)$ und ein Modul (21) zur Berechnung der inversen Frequenztransformierten, wobei diese Module den Dekodierer bilden und ein dekodiertes, verrauschtes Signal $x'(n)$ liefern, dadurch gekennzeichnet, daß die Einrichtung ferner einerseits auf Ebene des Kodierers (1) umfaßt

- ein Modul (13) zur Erfassung der Übergänge, welche durch den Rang N-q des Übergangs in dem betrachteten, laufenden Block gekennzeichnet sind,
- ein Modul (14) zur Extraktion der Parameter der Energie $\sigma^2 x(n)$ des Abtastwerts $x(n)$ oder einer Gruppe aufeinanderfolgender Abtastwerte des Ursprungssignals aus den Abtastwerten $x(n)$,
- ein Modul (15) zur Kodierung ausgehend von den Parametern der Energie $\sigma^2 x(n)$ des Abtastwerts $x(n)$ oder der Gruppe von Abtastwerten des Abtastwerteblocks, welches die kodierte Übertragung der Parameter der Energie $\sigma^2 x(n)$ und eines die Anwesenheit eines Übergangs in dem betrachteten Abtastwerteblock anzeigenden Signals ermöglicht, und andererseits

auf Ebene des Dekodierers (2)

- ein Modul (22) zur Rekonstruktion der übertragenen Parameter der Energie $\sigma^2 x(n)$,
- ein Modul (23) zur Extraktion der Parameter a1, a2 der Filterung aus den Abtastwerten $x(n)$ des vorhergehenden Blocks und zur Auswertung der Energien des Innovationsrauschens $\sigma^2 w(n)$ und des Kodierungsrauschens $\sigma^2 b(n)$ für den betrachteten Abtastwert vom Rang n,
- ein Modul (24) zur KALMAN-Filterung, welches am Filterungseingang das verrauschte, dekodierte Signal $x'(n)$ und am Steuereingang die Parameter der Filterung a1, a2 und der Auswertung der Energien des Kodierungsrauschens $\sigma^2 b(n)$ und des Innovationsrauschens $\sigma^2 w(n)$ empfängt, wobei das Filterungsmodul (24) am Ausgang das gefilterte, dekodierte Signal $xr(n)$ liefert.

4. Einrichtung nach Anspruch 3, dadurch gekennzeichnet, daß sie ferner einen Zwei-Wege-Umschalter (25) umfaßt, von dem ein erster Schaltweg das gefilterte, dekodierte Signal $xr(n)$ empfängt und von dem ein zweiter Schaltweg das von dem Modul (21) zur inversen Transformation gelieferte, dekodierte, verrauschte Signal $x'(n)$ empfängt, wobei der Umschaltsteuerungsweg von dem die Anwesenheit eines Übergangs in dem betrachteten Abtastwerteblock anzeigende Signal (t) gesteuert ist.

5. Einrichtung nach Anspruch 3 oder 4, dadurch gekennzeichnet, daß das Modul (14) zur Extraktion der Parameter der Energie $\sigma^2 x(n)$ der Abtastwerte $x(n)$ des Signals umfaßt

kaskadenartig angeordnet:

- ein Modul (140) zur Aufteilung jedes Blocks von N Abtastwerten in aufeinanderfolgende Unterblöcke einer festgelegten Anzahl von Abtastwerten,
- ein Modul (141) zur Berechnung der Energie $\sigma^2 x(j)$ eines Abtastwerts oder einer Gruppe von Abtastwerten des Ursprungssignals.

6. Einrichtung nach einem der Ansprüche 3 bis 5, dadurch gekennzeichnet, daß das Kodierungsmodul umfaßt:
   - einen einheitlichen Quantifizierer (151), welcher ausgehend von den Parameterwerten Kodeworte liefert,
   - eine Schaltung (152) zur Huffmann-Kodierung.

7. Einrichtung nach einem der Ansprüche 3 bis 6, dadurch gekennzeichnet, daß das Modul (23) zur Extraktion der Parameter der Filterung a1, a2 und der Auswertung der Energien des Kodierungsrauschens $\sigma^2 b(n)$ und des Rauschens $\sigma^2 w(n)$ parallel zu einem Eingangsanschluß der Abtastwerte $x'(n)$ des verrauschten, dekodierten Signals umfaßt
   - einen ersten Weg (A) zur Berechnung der Parameter der Filterung a1, a2 und der Varianz des Innovationsrauschens $\sigma^2 w(n)$ für den betrachteten Abtastwert vom Rang n,
   - einen zweiten Weg (B) zur Berechnung der Energie des Kodierungsrauschens $\sigma^2 b(n)$, wobei die Parameter der Filterung a1, a2, des Innovationsrauschens $\sigma^2 w(n)$ und des Kodierungsrauschens $\sigma^2 b(n)$ dem KALMAN-Filterungsmodul zugeführt werden.

8. Einrichtung nach Anspruch 7, dadurch gekennzeichnet, daß der erste Weg (A) kaskadenartig verbunden aufeinanderfolgend umfaßt:
   - einen Abtastwertspeicher (230), welcher die von dem Modul (21) zur inversen Transformation gelieferten, verrauschten Abtastwerte $x'(n)$ empfängt,
   - eine Schaltung (231) zur Berechnung der Koeffizienten der Voraussage (ai, a1, a2) und des Verstärkungsgrads der Voraussage Gp,
   - eine Schaltung (232) zur Berechnung der Varianz des Innovationsrauschens $\sigma^2 w(n)$ des Abtastwerts, wobei diese Schaltung einerseits den rekonstruierten Wert des Parameters der Energie $\sigma^2 x'(n)$ des übertragenen Abtastwerts empfängt, welcher von dem entsprechenden Modul (22) geliefert ist, und andererseits den Voraussageverstärkungsgrad Gp, wobei das Rauschen des Abtastwerts die Beziehung:

$$\sigma^2 w(n) = \sigma^2 x'(n)/Gp$$

   erfüllt.

9. Einrichtung nach Anspruch 7, dadurch gekennzeichnet, daß der zweite Weg (B) kaskadenartig verbunden aufeinanderfolgend umfaßt:
   - eine Schaltung (233) zur Berechnung des Parameters der Energie $\sigma^2 x'(n)$ des verrauschten Abtastwerts $x'(n)$, wobei dieser Energieparameter eine rekursive Beziehung der Form:

$$\sigma^2 x'(n) = \alpha.\sigma^2 x'(n - 1) + (1 - \alpha).x'^2(n)$$

   erfüllt, wobei eine Konstante ist, deren Wert zwischen Null und Eins liegt, und
   - eine Schaltung (235) zur Berechnung des Parameters des Kodierungsrauschens $\sigma^2 b(n)$ der Abtastwerte, wobei dieser Rauschparameter eine Beziehung der Form:

$$\sigma^2 b(n) = \sigma^2 x'(n) - \sigma^2 x(n)$$

   erfüllt.

## Claims

1. A method of processing the preechos of an audiodigital signal coded by frequency transform in which, after coding said signal by frequency transform as a coefficient y(k), over weighting windows formed over blocks of samples x(n) comprising N successive samples, on decoding the transform coefficients y(k) an optimal filtering is performed, so as to reduce, when in the presence of a transition in amplitude of the signal, the resulting additive noise when coding the quantization of the transform coefficients, characterized by said filtering performed on decoding being a KALMAN filtering.

2. The method as claimed in Claim 1, wherein the KALMAN filtering procedure being defined on the basis of a state equation defined in regression form of order 2 of the form :

$$x(n) = a1.x(n - 1) + a2.x(n - 2) + w(n)$$

where a1 and a2 designate the filter prediction coefficients and w(n) the innovation noise for the sample x(n) of rank n under consideration and of an observation relation of the form :

$$x'(n) = x(n) + b(n)$$

where b(n) designates the amplitude of the coding noise of preecho for this same sample x(n), x'(n) designating the sample of rank n of the noisy decoded signal and the sample of rank n of the filtered decoded signal being given by the relation :

$$xr(n) = a1.(1 - K1).xr(n - 1) + a2.(1 - K1).xr(n - 2) + K1.x'(n)$$

where K1 designates the filter gain value satisfying the relations :

$$K1 = P1(1)/(P1(1) + \sigma^2 b(n))$$
$$K2 = P1(3)/(P1(1) + \sigma^2 b(n))$$

the coefficients P1(1) and P1(3) being given by the matrix of the prediction error and by the matrix of the estimation error of the KALMAN filtering, $\sigma^2 b(n)$ designating the energy of the coding noise and $\sigma^2 w(n)$ designating the energy of the innovation noise w(n) for the sample x(n) of rank n under consideration, said method consists :

during the coding procedure,

- in determining, on the one hand, the energy $\sigma^2 x(n)$ of the sample x(n) of the original signal and, on the other hand, the existence of a transition at the level of at least one sample x(N-q) of rank N-q of a current determined block, then in transmitting at decoding level the value of the parameters for energy $\sigma^2 x(n)$ and for existence of the transition, and then,

during the decoding procedure,

- in estimating the filtering parameters, prediction coefficients a1, a2 of the filtering on the basis of the samples from the preceding block,
- in evaluating the energies of the coding noise $\sigma^2 b(n)$ and of the noise $\sigma^2 w(n)$ for the sample of rank n under consideration, this making it possible to secure, at the level of the decoding, the adaptive filtering of the noisy decoded signal x'(n) in order to reconstruct the filtered decoded signal in which the preechos are substantially suppressed.

3. A system for processing the preechos of an audiodigital signal coded by frequency transform, this system comprising, on the one hand, arranged in cascade at the level of the coder (1), a module (10) reading the samples x(n) of audio-digital signal constituting these latter as blocks of N samples, a module (11) for calculating the frequency transform, delivering on the basis of the said sample blocks, corresponding transform coefficients y(k), and a module (12) for coding by quantizing these coefficients with a view to transmitting them by way of a digital transmission channel and, on the other hand, arranged in cascade at the level of the decoder (2), for reception of the transmission channel, a module (20) for decoding the coefficients y(k) and a module (21) for calculating the inverse frequency transform, these modules constituting the decoder and delivering a noisy decoded signal x'(n), characterized by said system further comprising, on the one hand at the level of the coder (1),

- a module (13) for detecting the transitions labelled by the rank N-q of the transition in the current block under consideration,
- a module (14) for extracting, from the samples x(n), parameters of energy $\sigma^2 x(n)$ of the sample x(n) or of a group of successive samples of the original signal,
- a module (15) for coding, from the parameters of energy $\sigma^2 x(n)$ of the sample x(n) or of the group of samples of the block of samples permitting the coded transmission of the parameters of energy $\sigma^2 x(n)$ and of a signal indicating the presence of a transition in the sample block under consideration and, on the other hand, at the level of the decoder (2),
- a module (22) for reconstructing transmitted energy parameters $\sigma^2 x(n)$,
- a module (23) for extracting the filtering parameters a1, a2, from the samples x(n) of the preceding block and for evaluating the energies of the innovation noise $\sigma^2 w(n)$ and of the coding noise $\sigma^2 b(n)$ for the sample of rank n under consideration,
- a module (24) for KALMAN filtering, receiving as filtering input the noisy decoded signal x'(n) and as control input said filtering parameters a1, a2 and parameters of evaluation of the energies of the coding noise $\sigma^2 b(n)$ and of the innovation noise $\sigma^2 w(n)$, said filtering module (24) delivering as output the filtered decoded signal xr(n).

4. The system as claimed in Claim 3, characterized by further comprising a two-path switch (25), of which a first switched path receives said filtered decoded signal xr(n), and of which a second switched path receives said noisy decoded signal x'(n) delivered by the inverse transform module (21), the switching control path being driven by said signal (t) indicating the presence of a transition in the sample block under consideration.

5. The system as claimed in Claim 3 or 4, characterized by said module (14) for extracting the parameters of energy $\sigma^2 x(n)$ of the samples x(n) of the signal comprising, arranged in cascade :

- a module (140) for partitioning each block of N samples into sub-blocks of a determined number of successive samples,
- a module (141) for calculating the energy $\sigma^2x(j)$ of a sample or of a group of samples of the original signal.

6. The system as claimed in one of Claims 3 to 5, wherein the coding module comprises :
   - a uniform quantizer (151) delivering, from the parameter values, code words,
   - a Huffmann coding circuit (152).

7. The system as claimed in one of Claims 3 to 6, characterized by said module (23) for extracting the filtering parameters a1, a2 and for evaluating the energies of the coding noise $\sigma^2b(n)$ and of the noise $\sigma^2w(n)$ comprises, in parallel with an input port for the samples $x'(n)$ of the noisy decoded signal,
   - a first path (A) for calculating the filtering parameters a1, a2 and the variance of the innovation noise $\sigma^2w(n)$ for the sample of rank n under consideration,
   - a second path (B) for calculating the energy of the coding noise $\sigma^2b(n)$, the filtering parameters a1, a2 and the parameters of the innovation noise $\sigma^2w(n)$ and of the coding noise $\sigma^2b(n)$ being delivered to the KALMAN filtering module.

8. The system as claimed in Claim 7, characterized by said first path (A) comprising in succession connected in cascade :
   - a sample memory (230) receiving the noisy samples $x'(n)$ delivered by the inverse transformation module (21),
   - a circuit (231) for calculating the prediction coefficients (ai, a1, a2) and prediction gain Gp,
   - a circuit (232) for calculating the variance of the sample innovation noise $\sigma^2w(n)$, a circuit receiving, on the one hand, the reconstructed value of the transmitted sample's energy parameter $\sigma^2x'(n)$, delivered by the corresponding module (22) and, on the other hand, the prediction gain Gp., the sample noise satisfying the relation :

$$\sigma^2w(n) \; = \; \frac{\sigma^2x'(n)}{Gp}$$

9. The system as claimed in Claim 7, characterized by said second path (B) comprising in succession connected in cascade :
   - a circuit (233) for calculating the energy parameter $\sigma^2x'(n)$ of the noisy sample $x'(n)$, this energy parameter satisfying a recurrence relation of the form :
   $$\sigma^2x'(n) \; = \; \alpha.\sigma^2x'(n - 1) + (1 - \alpha).x'^2(n),$$
   where $\alpha$ is a constant with value lying between zero and one,
   - a circuit (235) for calculating the coding noise parameter $\sigma^2b(n)$ for the samples, this noise parameter satisfying a relation of the form :
   $$\sigma^2b(n) \; = \; \sigma^2x'(n) \; - \; \sigma^2x(n).$$

FIG.1a. (art antérieur)

FIG. 1b (art antérieur)

FIG.1c. (art antérieur)

I Signal original attaque vibraphone échantillonnée 32 kHz

II Signal décodé et reconstruit par codage par transformée
TCDM à 64 k bits/s

# FIG.2.

Identification de la transition et extraction des paramètres d'énergie

t

$C,M$
$C\sigma^2 x(n)$

$\}Cp$

Transmission vers décodage

$x(n)$ Lecture des echantillons

$x(n)$

CODAGE

Transformation TCDM $y(k)$

Codage des coefficients H

$cy(k)$

---

Décision "bloc à préechos ou non"

t

$Cp\{$ $C,M$
$C\sigma x'(n)$

Reconstruction des paramètres d'énergie transmis $H^{-1}$

$M$
$\sigma^2 x'(n)$

$a1, a2$
$\sigma^2 b(n)$
$\sigma^2 w(n)$

Filtrage optimal

$x_r(n)$

Extraction des paramètres de filtrage

S

Bloc courant

Bloc antérieur

$S=t.Xr(n)+\bar{t}.X'(n)$

$Cy(k)$ Décodage des coefficients $H^{-1}$

$y(k)$

Transformation inverse $TCDM^{-1}$

$x'(n)$

Detection des transitions — 13

Lecture des échantillons

x(n)

x(n)

Extraction des paramètres d'énergie — 14

$\sigma^2 x(n)$

M

Codage des paramètres — 15

t

Cp

C,M
$C\sigma^2 x(n)$

CT

10

CODEUR

Transformation TCDM — 11

y(k)

Codage des coefficients — 12

CT

1

## FIG.3a.

Décision "bloc à prééchos ou non"

t

C,M
$C\sigma^2 x(n)$

CT

Reconstruction du paramètre d'énergie transmis
$H^{-1}$  $\sigma^{-2} x'(n)$ — 22

M

$\sigma^2 x'(n)$

24

a1, a2
$\sigma^2 b(n)$
$\sigma^2 w(n)$

Bloc K
Filtrage
de Kalman

$x_r(n)$

23

Extraction des paramètres de filtrage

x'(n)

25

S

2

CT

Cy'(k)

Décodage des coefficients
$H-1$ — 20

DECODEUR

Transformation inverse
$TCDM^{-1}$ — 21

x'(n)

x'(n)

x'(n)

x'(n)

## FIG.3b.

# FIG.4b.

# FIG.4a.

FIG.5.
 I Signal d'origine, attaque de guitare échantillonnée à 32 kHz
   durée 32 ms
 II Signal codé sans traitement des prééchos débit 64 Kb/s
 III Signal codé avec traitement des prééchos